(19) Europäisches Patentamt
European Patent Office
Office européen des brevets

(11) **EP 0 678 750 B1**

(12) **EUROPÄISCHE PATENTSCHRIFT**

(45) Veröffentlichungstag und Bekanntmachung des Hinweises auf die Patenterteilung:
**14.07.1999 Patentblatt 1999/28**

(51) Int Cl.⁶: **G01R 19/00**, G01R 31/315, G01R 31/08

(21) Anmeldenummer: **94106240.8**

(22) Anmeldetag: **21.04.1994**

(54) **Vorrichtung und Verfahren zur Strommessung**

Appliance and method for measuring current

Dispositif et méthode pour mesurer du courant

(84) Benannte Vertragsstaaten:
**AT BE CH DE DK ES FR GB GR IE IT LI LU MC NL PT SE**

(43) Veröffentlichungstag der Anmeldung:
**25.10.1995 Patentblatt 1995/43**

(73) Patentinhaber: **Kleindienst Datentechnik GmbH & Co. KG**
**D-86165 Augsburg (DE)**

(72) Erfinder: **Walsdorf, Klaus**
**D-86199 Augsburg (DE)**

(74) Vertreter:
**Herrmann-Trentepohl, Werner, Dipl.-Ing. et al**
**Patentanwälte**
**Herrmann-Trentepohl**
**Grosse - Bockhorni & Partner**
**Forstenrieder Allee 59**
**81476 München (DE)**

(56) Entgegenhaltungen:
**DE-A- 1 807 643        DE-A- 3 111 393**
**DE-A- 4 031 827        US-A- 3 719 883**

- **ELEKTOR ELECTRONICS, Bd.18, Nr.206, Dezember 1992, LONDON,GB Seite 81-82, XP000320913 'current probe for pcb tracks'**

**Beschreibung**

Die vorliegende Erfindung bezieht sich auf eine Vorrichtung und ein Verfahren zur Strommessung gemäß dem Oberbegriff von Patentanspruch 1 bzw. 8.

Es sind verschiedene Verfahren zur Messung des Stromes in einzelnen Elementen eines Schaltkreises bekannt. Diese Verfahren erfordern im allgemeinen die Unterbrechung von Leiterbahnen oder eine Abtrennung von Beinen eines intergierten Schaltkreises, um den lokalen Stromfluß durch bestimmte Elemente zu messen.

Der Nachteil dieser herkömmlichen Verfahren ist, daß der Stromfluß nur an den Stellen gemessen werden kann, wo eine solche Unterbrechung oder Abtrennung möglich ist. Zudem besteht die Gefahr, daß der Schaltkreis teilweise zerstört wird.

Die Druckschrift US-A-3 719 883 betrifft eine magnetische Kernschaltung für das Testen von elektrischen Kurzschlußschaltungen zwischen den Leitungen einer Schaltungsanordnung mit einer Vielzahl von Leitungen, wobei diese Art von Strom-Meßvorrichtung nur verwendet werden kann, wenn innerhalb einer Schaltung ein Kurzschluß auftritt oder wenn eine offene Schaltung vorhanden ist. Diese Strom-Meßvorrichtung beinhaltet nicht Einrichtungen zum Anlegen einer zusätzlichen Gleichspannung an eine Schaltung, um die zu untersuchenden Stromkreise zu öffnen.

Die Aufgabe der vorliegenden Erfindung ist es, eine Vorrichtung und ein Verfahren anzugeben, die die Nachteile des Standes der Technik vermeiden.

Die Aufgabe wird gelöst durch eine Vorrichtung gemäß Patentanspruch 1 und ein Verfahren gemäß Patentanspruch 8. Vorteilhafte Ausgestaltungen der Erfindungen sind in den Unteransprüchen gekennzeichnet.

Mit Hilfe der Erfindung können gezielt Ströme in komplexen elektronischen Schaltungen lokalisiert und ihre Größe bestimmt werden ohne Leitungsunterbrechungen durchführen zu müssen.

Ein weiterer Vorteil ist, daß der zu untersuchende Bauteilträger während der Messung keine Betriebsspannung erhält.

Vorteilhaft lassen sich auch bei Busstrukturen, wie sie in komplexen digitalen Schaltungen auftreten, Teilströme in einem Verhältnis von 1 zu 100 und größer ermitteln. Unter Busstrukturen versteht man im allgemeinen den Zusammenschluß verschiedener IC-Anschlüsse zum Zwecke des gemeinsamen Datentransports. Da auf einem solchen Bussystem viele ICs angeschlossen sein können, die auch noch unterschiedliche Technologien besitzen wie beispielseise TTL und CMOS, sind Messungen mit den herkömmlichen Techniken besonders schwierig.

Somit ist die Erfindung geeignet, gezielt Strommessungen in Testsystemen vorzunehmen, um das korrekte Vorhandensein der einzelnen Bausteine und deren Anschlüsse zu überprüfen.

Die Erfindung kann als "Inductive Boundary Scan" (IBS) bezeichnet werden und funktioniert im Prinzip wie folgt: Ein Sender, vorzugsweise in Form eines kleinen, offenen Ringspulenkerns, wird ähnlich einem Tonkopf eines Tonbandes über den zu untersuchenden Schaltkreis bewegt. Diese Spule wird mit einem hochfrequenten Strom beaufschlagt. Die hochfrequenten Magnetfelder der Spule induzieren der lokalen Umgebung der Spule eine Spannung. Wird nun gezielt beispielsweise ein IC-Anschluß angefahren, der mit einer zusätzlichen Hilfspannung belegt wurde, welche Halbleiterstrecken im IC öffnet, so moduliert sich diese hochfrequente Spannung auf den durch Halbleiterstrecken fließenden Gleichstrom.

Mit Hilfe beispielsweise eines auf diese Frequenz abgestimmten Verstärkers kann dieses aufmodulierte Signal auf der Zuleitung zu diesem Knotenpunkt (IC-Bein) nachgewiesen werden. Bei konstanter Ausgangsimpedanz der Gleichstromquelle kann mit Hilfe des Modulationsgrades auf die Größe des fließenden Stromes geschlossen werden.

Die Erfindung ermöglicht auch die Vermessung von Schaltkreisen, deren Ein- und Ausgänge unmittelbar miteinander verbunden sind.

Vorteilhaft kann die Abmessung der Spule so dimensioniert werden, daß sich damit auch der korrekte Einbau von IC's ermitteln läßt, bei denen ein oder mehrere Anschlüsse unmittelbar im Layout parallel liegen.

Der Stromfluß durch einen IC-Fuß kann in einzelnen Fällen auch dadurch erreicht werden, daß eine positive Spannung angelegt wird. Dies ist insbesondere bei CMOS-ICs wirkungsvoll.

Das Prinzip und die Vorteile der Erfindung wird besser verstanden werden anhand der folgenden Beaschreibung einer bevorzugten Ausführungsform in Verbindung mit den begleitenden Zeichnungen, in welchen:

Figur 1 eine schematische Darstellung einer bevorzugten Ausführungsform einer Vorrichtung gemäß der Erfindung zeigt.

Figur 2a - 2c schematische Schaltkreise zur Erläuterung des Erfindungsprinzips zeigen.

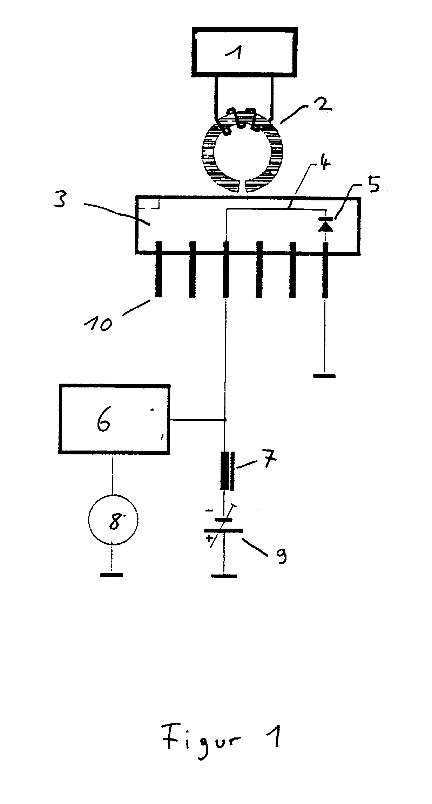

In Figur 1 ist ein Leistungsoszillator 1 mit einer Magnetsonde in Form einer Spule 2 induktiv gekoppelt. Die Sonde 2 wird über einen integrierten Schaltkreis 3 geführt, welcher Bonddrähte 4, Halbleiterstrecken 5, Leiterbahnen und Anschlußbeine 10 des Schaltkreises umfaßt. Die Bonddrähte sind mit einer Seite eines selektiven Verstärkers/Gleichrichters 6 und einer Seite einer Drossel 7 verbunden. Die andere Seite des Verstärkers/Gleichrichters 6 ist an einen Voltmeter 8 angeschlossen. Die andere Seite der Drossel liegt an einer programmierbaren Spannungsquelle 9 an.

In der oben beschiebenen Ausführungsform wird die erfindungsgemäße Vorrichtung in der Weise betrieben, daß die Sonde 2 beispielsweise mit Hilfe einer X-Y-Z-Steuerung über die zu untersuchende Platine geführt wird. Das Magnetfeld kann dabei so ausgelegt werden, daß es gezielt einen IC-Fuß oder das gesamte IC moduliert. Nach jeder Positionierung wird gleichzeitig der zu untersuchende Leiterknotenpunkt mit einer Gleichspannung stimuliert. Die Amplitude des gemessenen HF-Signales gibt Auskunft über das Vorhandensein des jeweiligen bestrahlten ICs und dessen inneren Beschaltung. Diese Anwendung ist besonders für das bekannte Flying-Probe-Verfahren geeignet, da dort nur mit wenigen Tastspitzen gearbeitet werden kann (Kleinserien, verlackte Platinen, etc.).

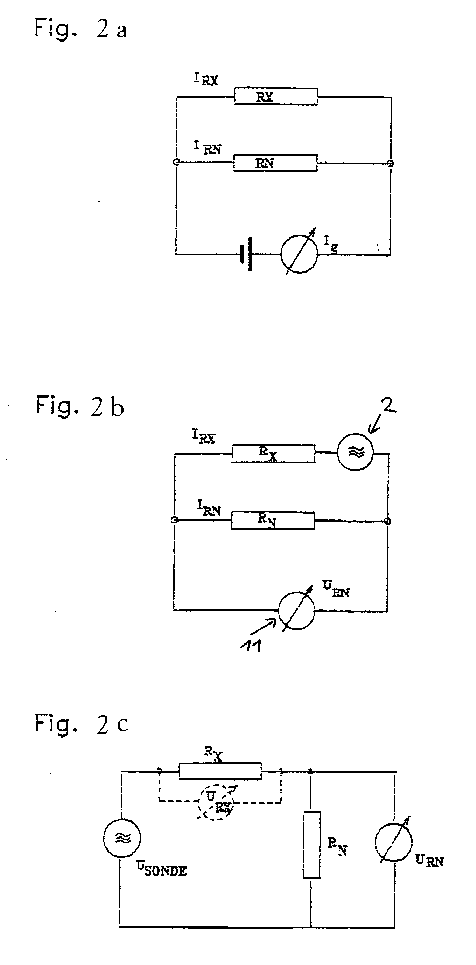

Das Prinzip der Erfindung läßt sich anhand der Figuren 2a - 2c verdeutlichen. In Figur 2a zeigt die herkömmliche Gleichstrommessung in einem konventionellen Testsystem. Dabei symbolisiert RN die Summe aller Nebenwiderstände der Schaltung, durch die die parasitären Ströme erzeugt werden, und $I_{RX}$ ist der als unbekannt zu ermittelnde Strom des zu untersuchenden IC-Anschlusses.

Nach den Regeln des ohmschen Gesetzes verhalten sich die Ströme in einer Parallelschaltung umgekehrt proportional zu den Widerstandswerten. Somit gilt für den Schaltkreis von Figur 2a:

$$\frac{I_{RX}}{I_{RN}} = \frac{RN}{RX}$$

Figur 2b zeigt das Verhalten der gleichen Schaltung bei Einspeisung einer HF-Spannung mittels der Sonde 2 im Stromzweig $I_{RX}$. Das HF-Voltmeter 11 ermittelt die Spannung über den Widerstand RN.

Zur besseren Erklärung ist noch Figur 2c gegeben, die eine andere Darstellung des Schaltkreises von Figur 2b zeigt. Bedingt durch die Sondeneinspeisung verhält sich die ursprüngliche Parallelschaltung unter Betrachtung der HF-Regeln jetzt wie eine Serienschaltung. Die Spannungen in einer Serienschaltung verhalten sich proportional zu den Widerständen. Somit gilt für diese Schaltung:

$$\frac{RN}{RX} = \frac{U_{RN}}{U_{RX}}$$

Da es sich bei dieser Schaltung um dasselbe Widerstandnetzwerk handelt, verhalten sich die Ströme nach Figur 2a umgekehrt proportional wie die Spannungen in der Schaltung nach Figur 2c:

$$\frac{I_{RX}}{I_{RN}} = \frac{U_{RN}}{U_{RX}}$$

Folglich gilt auch

$$\frac{I_G}{I_{RX}} = \frac{U_{Sonde}}{U_{RN}}$$

woraus sich der gesuchte Strom ergibt nach:

$$I_{RX} = \frac{U_{RN} * I_G}{U_{Sonde}}$$

Aus der Messung nach Figur 2a ist der Summenstrom $I_G$ bekannt und aus der Messung nach Figur 2c ist das Stromverhältnis bekannt. Die Sondenspannung $U_{Sonde}$ kann mit gewissen Toleranzen als bekannt vorausgesetzt werden. Abweichungen von der tatsächlichen Sondenspannung könnten sich höchstens aus einer schlechten Einkopplung der Sonde ergeben und zu kleineren $I_{RX}$-Werten führen. Dies ist aber angesichts des Meßproblems von geringer Bedeutung. In der Paxis wird eine tendenzielle Aussage genügen.

Exemplarstreuungen bei IC's von verschiedenen Herstellern treten nur unwesentlich in Erscheinung. Praktische Messungen haben auch in diesen Fällen zu eindeutigen Aussagen geführt.

Auch in Busstrukturen, in denen TTL- und CMOS-Bausteine gemeinsam auftreten, kann die Erfindung vorteilhaft angewendet werden.

Ebenso lassen sich elektronische Bausteine eindeutig vermessen, bei denen zwei oder mehrere Anschlüsse unmittelbar auf dem selben Potential liegen.

Die Erfindung kann vorteilhaft kombiniert werden mit dem Chip-Scanner "Scorpion Tester" der Firma ITA, der in der Patentschrift DE 41 10 551 C1 beschrieben ist.

Dieses bekannte Gerät beruht auf einem Verfahren, wonach parasitäre Transistoren, welche in den meisten digitalen ICs vorhanden sind, ohne Anlegen einer Betriebsspannung vermessen werden. Dabei ist es notwendig, von einem guten Bauteilträger Referenzströme zu bestimmen.

Um aber den Strom des zu untersuchenden Bauteilanschlußes als Kriterium für die Gut-Schlecht-Aussage heranziehen zu können, muß dieser Strom quantitativ bewertet werden. In der Praxis werden dazu meistens aufwendige Bauteiladapter mit Schaltmöglichkeit an den einzelnen Bauteilanschlüssen angefertigt. Bei zunehmender Integrationsdichte und mit Einführung der SMD-Technik ist eine solche Adaption fast nicht mehr realisierbar. Mit Hilfe der Erfindung kann jedoch dieser Strom ohne jegliche Leitungstrennung ermittelt werden. Nicht gewollte Nebenströme, welche automatisch auf dem Meßknotenpunkt auftreten, können dabei ausgeblendet werden. Somit erleichtert die Erfindung wesentlich die Programmherstellung beim besagten Scorpion-Tester.

Die praktische Anwendung der Erfindung in Verbindung mit dem Scorpion-Tester hat die folgenden vorteilhaften Ausführungsformen nahegelegt: Um einen IC-Fuß gezielt zu stimulieren, sollte der Stimuluskopf (Sonde) 2 ein kräftiges Magnetfeld erzeugen, dabei ist die Sonde für elektrische Felder gut abzuschirmen. Um das Magnetfeld schmal zu halten, wurde um den Stimuluskopf (Sonde) eine Lage MU-Metall gewickelt. Die Stimulusfrequenz muß groß genug sein, um eine ausreichende Modulation zu erreichen. Andererseits darf sie nicht zu groß sein, da sonst die parasitären Kapazitäten der Schaltung eine Modulation verhindern. In der praktischen Anwendung wurde eine sinusförmige Spannung mit einer Frequenz von 200 kHz, auf die magnetische Meßsonde gegeben. Die Magnetfeldstärke wurde so gewählt, daß sie in einem am Magnetkopf vorbei laufenden Draht eine Spannung von ca. 80 mV induziert. Dieses Magnetfeld und die daraus resultierende induzierte Spannung kann auf keinen Fall zu Beschädigungen an den Bausteinen führen.

Der selektive Verstärker/Gleichrichter 6 wurde für eine Eingangsempfindlichkeit von ca. 1 mV bis 50 mV ausgelegt.

Für eine ausreichende Abschirmung zwischen Sender- und Empfangsteil (Sonde und Verstärker/ Gleichrichter) ist zu sorgen.

Die gesamte Hardware des Meßaufbaus ist galvanisch vom Netz zu trennen, um keine Fehlmessungen beim Scorpion-Tester zu bewirken.

Der HF-Fußpunktwiderstand der Gleichsspannungsquelle sollte beim Scorpion-Tester durch Einbau einer HF-Drossel (HF = Hochfrequenz) erhöht werden, um eine ausreichende Meßempfindlichkeit zu erreichen. Wird der ohmsche Anteil dieser Drossel klein gehalten, so nimmt er keinen Einfluß auf die Meßergebnisse des Scorpion-Testers. Schnell ablaufende Messungen (100μs) des Scorpion-Testers könnten durch den Einbau der Drossel verfälscht werden.

Da die Teilstromermittlungen nur für die Debug-Phase von Interesse sind, kann diese Drossel abgeschaltet werden, nachdem die Programmentwicklung abgeschlossen ist.

**Patentansprüche**

1.   Vorrichtung zur Messung von elektrischen Strömen in Schaltkreisen (3) mit Leiterbahnen, Anschlüssen (10) und Halbleiterstrecken (5), mit einer Sendeeinrichtung (1, 2), welche ein hochfrequentes Magnetfeld in einer lokalen Umgebung um die Sendeeinrichtung erzeugt, und einer Empfangseinrichtung (6), welche ein Signal empfängt, das durch das hochfrequente Magnetfeld in dem Schaltkreis induziert wird,
**gekennzeichnet durch**
Einrichtungen zum Anlegen einer zusätzlichen Gleichspannung an die Schaltkreise.

2.   Vorrichtung nach Anspruch 1, **dadurch gekennzeichnet,** daß die Sendeeinrichtung (1, 2) teilweise beweglich oder fest positioniert über den zu vermessenden Schaltkreis (3) angebracht wird.

3.   Vorrichtung nach Anspruch 1 oder 2, **dadurch gekennzeichnet**, daß die Sendeeinrichtung einen offenen Ringspulenkern (2) umfaßt.

4.   Vorrichtung nach nach einem der vorangegangenen Ansprüche, **dadurch gekennzeichnet,** daß die Sendeeinrichtung einen Oszillator (1) umfaßt.

5.   Vorrichtung nach einem der vorangegangenen Ansprüche, **dadurch gekennzeichnet,** daß die Empfangseinrichtung (6) einen auf die Frequenz des hochfrequenten Magnetfeldes abgestimmten Verstärker umfaßt.

6.   Vorrichtung nach einem der vorangegangenen Ansprüche, **dadurch gekennzeichnet,** daß die Empfangseinrichtung (6) mit einem Voltmeter (8) verbunden ist.

7.   Vorrichtung nach einem der vorangegangenen Ansprüche, **dadurch gekennzeichnet,** daß mindestens ein Teil der Sendeeinrichtung (2) mit einem Metall zur mindestens teilweisen Abschirmung von elektrischen Feldern umwickelt ist.

8.   Verfahren zur Messung von elektrischen Strömen in Schaltkreisen (3) mit Leiterbahnen, Anschlüssen (10) und Halbleiterstrecken (5), worin mittels eines hochfrequenten Magnetfeldes in einem Teil des Schaltkreises (3) ein Signal moduliert wird, aus dem ein lokaler Stromfluß in den Schaltkreis ermittelt werden kann, **dadurch gekennzeichnet,** daß mindestens ein Teil des Schaltkreises mit einer Hilfsspannung belegt wird, welche mindestens eine Halbleiterstrecke (5) in dem Schaltkreis öffnet, und das hochfrequente Magnetfeld den durch die Halbleiterstrecke fließenden Strom moduliert und dessen Modulationsgrad mittels einer abstimmbaren Verstärkungseinrichtung (6) ermittelt wird.

9.   Verfahren nach Anspruch 8, **dadurch gekennzeichnet,** daß die Einstrahlung des hochfrequenten Magnetfeldes direkt auf einen Anschluß des Schaltkreises erfolgt.

10.   Verfahren nach Anspruch 8, **dadurch gekennzeichnet**, daß die Einstrahlung des hochfrequenten Magnetfeldes direkt in eine Leiterbahn des Schaltkreises, erfolgt.

11.   Verfahren nach einem der Ansprüche 8 bis 10, **dadurch gekennzeichnet**, daß nach jeder Positionierung der Einstrahlung gleichzeitig ein zu untersuchender Leiterknotenpunkt des Schaltkreises mit einer Gleichspannung stimuliert wird, wobei die Amplitude des gemessenen HF-Signals Auskunft über das Vorhandensein des jeweiligen bestrahlten Schaltkreises und dessen innere Beschaltung gibt.

**12.** Verfahren nach einem der Ansprüche 8 bis 11, **dadurch gekennzeichnet**, daß die Frequenz des hochfrequenten Magnetfeldes ungefähr 200 kHz beträgt.

## Claims

**1.** Device for measurement of electrical currents in circuits (3) with tracks, connections (10) and semiconductor paths (5), with a transmitter device (1, 2) which generates a high frequency magnetic field in a local environment about the transmitter device, and a receiver device (6) which receives a signal induced by the high frequency magnetic field in the circuit, characterised by devices for application of an additional DC voltage to the circuits.

**2.** Device according to claim 1, characterised in that the transmitter device (1, 2) is arranged partly mobile or fixedly positioned over the circuit (3) to be measured.

**3.** Device according to claim 1 or 2, characterised in that the transmitter device comprises an open toroid core (2).

**4.** Device according to any of the previous claims, characterised in that the transmitter device is an oscillator (1).

**5.** Device according to any of the previous claims, characterised in that the receiver device (6) comprises an amplifier set to the frequency of the high frequency magnetic field.

**6.** Device according to any of the previous claims, characterised in that the receiver device (6) is connected to a voltmeter (8).

**7.** Device according to any of the previous claims, characterised in that at least part of the transmitter device (2) is enveloped in a metal for partial screening of electrical fields.

**8.** Process for measurement of electric current in circuits (3) with tracks, connections (10) and semiconductor paths (5) in which by means of a high frequency magnetic field in part of the circuit (3) a signal is modulated from which can be determined a local current flow in the circuit, characterised in that at least part of the circuit is subjected to an auxiliary voltage which opens at least one semiconductor path (5) in the circuit and the high frequency magnetic field modulates the current flowing through the semiconductor path and its degree of modulation is determined by means of an adjustable amplification device (6).

**9.** Process according to claim 8, characterised in that the irradiation of the high frequency magnetic field takes place directly onto a connection of the circuit.

**10.** Process according to claim 8, characterised in that the irradiation of the high frequency magnetic field takes place directly into a track of the circuit.

**11.** Process according to any of claims 8 to 10, characterised in that after each positioning of the irradiation, at the same time a conductor node point of the circuit to be tested is stimulated with a DC voltage, where the amplitude of the measured HF signal gives information on the presence of the radiated circuit concerned and its inner connections.

**12.** Process according to any of claims 8 to 11, characterised in that the frequency of the high frequency magnetic field is around 200 kHz.

## Revendications

**1.** Dispositif pour mesurer des courants électriques dans des circuits (3) comportant des voies conductrices, des bornes (10) et des sections semiconductrices (5), comportant un dispositif d'émission (1,2), qui produit un champ magnétique à haute fréquence dans un environnement local autour du dispositif d'émission, et un dispositif de réception (6), qui reçoit un signal, qui est induit par le champ magnétique à haute fréquence dans le circuit,
caractérisé par
des dispositifs pour appliquer une tension continue supplémentaire aux circuits.

**2.** Dispositif selon la revendication 1, caractérisé en ce que le dispositif d'émission (1,2) est monté de manière à être partiellement mobile ou en étant positionné de façon fixe au-dessus du circuit (3) à mesurer.

**3.** Dispositif selon la revendication 1 ou 2, caractérisé en ce que le dispositif d'émission comprend un noyau de bobine toroïdale ouvert (2).

**4.** Dispositif selon l'une des revendications précédentes, caractérisé en ce que le dispositif d'émission comprend un oscillateur (1).

**5.** Dispositif selon l'une des revendications précédentes, caractérisé en ce que le dispositif de réception (6) comprend un amplificateur accordé sur la fréquence du champ magnétique à haute fréquence.

6. Dispositif selon l'une des revendications précédentes, caractérisé en ce que le dispositif de réception (6) est relié à un voltmètre (8).

7. Dispositif selon l'une des revendications précédentes, caractérisé en ce qu'au moins une partie du dispositif d'émission (2) est enveloppée par au moins un métal servant à réaliser une protection au moins partielle vis-à-vis de champs électriques.

8. Procédé pour mesurer des courants électriques dans des circuits (3) comportant des voies conductrices, des bornes (10) et des sections semiconductrices (5), selon lequel un champ magnétique à haute fréquence dans une partie du circuit magnétique (3) module un signal à partir duquel un flux de courant local dans le circuit peut être déterminé, caractérisé en ce qu'on applique à au moins une partie du circuit une tension auxiliaire, qui ouvre au moins une section à semiconducteurs (5) dans le circuit, et que le champ magnétique à haute fréquence module le courant circulant dans la section à semiconducteurs et que son degré de modulation est déterminé au moyen d'un dispositif d'amplification accordable (6).

9. Procédé selon la revendication 8, caractérisé en ce que l'irradiation du champ magnétique à haute fréquence s'effectue directement sur une borne du circuit.

10. Procédé selon la revendication 8, caractérisé en ce que l'irradiation du champ magnétique à haute fréquence s'effectue directement dans une voie conductrice du circuit.

11. Procédé selon l'une des revendications 8 à 10, caractérisé en ce qu'après chaque positionnement de l'irradiation, le conducteur devant être examiné du circuit est simultanément stimulé avec une tension continue, l'amplitude du signal HF mesuré fournissant une indication sur la présence du circuit respectif irradié et de son câblage.

12. Procédé selon l'une des revendications 8 à 11, caractérisé en ce que la fréquence du champ magnétique à haute fréquence est égale approximativement à 200 kHz.

Figur 1

Fig. 2 a

Fig. 2 b

Fig. 2 c